# EUROPEAN PATENT SPECIFICATION

(11) **EP 4 238 929 B1**
(45) Date of publication and mention of the grant of the patent: **12.03.2025**
(21) Application number: 21902236.5
(22) Date of filing: 21.10.2021
(51) Int. Cl.: B81C 1/00

(54) **INERTIAL SENSOR AND FORMATION METHOD THEREFOR**
TRÄGHEITSSENSOR UND HERSTELLUNGSVERFAHREN DAFÜR
CAPTEUR INERTIEL ET SON PROCÉDÉ DE FORMATION

(30) Priority: 07.12.2020 CN 202011413591
(43) Date of publication of application: 06.09.2023
(73) Proprietor: United Nova Technology Co., Ltd., Shaoxing, Zhejiang 312000 (CN)
(72) Inventor: ZHANG, Zhaolin, Shaoxing, Zhejiang 312000 (CN); XU, Jihui, Shaoxing, Zhejiang 312000 (CN)
(74) Representative: Kraus & Lederer PartGmbB
(86) International application number: PCT/CN2021/125443
(87) International publication number: WO 2022/121529

(56) References cited:
- EP-A2- 1 046 917
- CN-A- 101 913 552
- CN-A- 103 121 658
- CN-A- 105 523 520
- CN-A- 105 621 348
- CN-A- 105 621 348
- CN-A- 110 467 148
- CN-A- 112 194 097
- CN-A- 112 624 031
- US-A1- 2016 320 258
- US-B1- 9 550 668

## Description

### TECHNICAL FIELD

The present invention relates to the technical field of semiconductors, and more particularly relates to an inertial sensor and a forming method thereof.

### BACKGROUND

An inertial sensor manufactured based on a micro-electro-mechanical system (MEMS) has drawn extensive attention due to its advantages such as simple structure, good compatibility with a microelectronics manufacturing process, mass manufacturing, and small volume.

In the existing process, a forming method of the inertial sensor generally includes: first providing a first substrate and a second substrate which are mutually bonded; and then, etching the second substrate to form a movable comb tooth structure and suspending the movable comb tooth structure above the first substrate. However, the inertial sensor prepared based on the existing process usually has the problem that side walls of comb teeth of the movable comb tooth structure are damaged.

Inertial sensors according to the state of the art are known, for instance, from prior art documents CN 105 621 348 A, and EP 1 046 917 A2.

### SUMMARY

An objective of the present invention is to provide a forming method of an inertial sensor, so as to alleviate damage to side walls of comb teeth of a formed movable comb tooth structure.

To solve the above technical problem, the present invention provides a forming method of an inertial sensor, according to claim 1, which includes:
providing a first substrate with a first conducting material layer and a second substrate with a second conducting material layer, where a trench is formed in a surface of a comb tooth region of the second conducting material layer, and a thin film layer is further formed at a bottom of the trench;
mutually bonding the second conducting material layer and the first conducting material layer; and
etching at least the comb tooth region of the second conducting material layer, and stopping etching at the thin film layer to form a movable comb tooth structure, where bottoms of comb teeth in the movable comb tooth structure are all fixed to the thin film layer; and
removing the thin film layer.

Optionally, a thickness of the thin film layer is less than a depth of the trench.

Optionally, after bonding the second conducting material layer and the first conducting material layer, the forming method further includes: forming a plurality of electrodes on the second conducting material layer, where at least part of the plurality of electrodes are used for being electrically connected to the movable comb tooth structure.

Optionally, first openings are further formed in the first conducting material layer, and when etching the second conducting material layer, second openings are further formed in the second conducting material layer. The second openings communicate with the first openings to form separation openings, and the plurality of electrodes are electrically isolated from each other by the separation openings.

Optionally, the first substrate further includes a first base and a first insulating layer formed between the first base and the first conducting material layer.

Optionally, a first cavity is formed in the first conducting material layer, and after bonding the first conducting material layer and the second conducting material layer, the comb tooth region is suspended above the first cavity.

Optionally, the second conducting material layer is further provided with a cantilever region, a second cavity and a stopper are further formed in the first conducting material layer, and after bonding the first conducting material layer and the second conducting material layer, the second cavity and the stopper are both located directly under the cantilever region.

Optionally, the second substrate further includes a second base and a second insulating layer formed between the second base and the second conducting material layer. Before etching the second conducting material layer, the forming method further includes: grinding the second base to partially remove the second base, then etching the remaining second base by an etching process, stopping etching at the second insulating layer, and then removing the second insulating layer to expose the second conducting material layer.

Optionally, the method for etching the second conducting material layer to form the movable comb tooth structure includes: adopting a plasma etching process for etching the second conducting material layer.

Another objective of the present invention is to provide an inertial sensor, according to claim 11, which includes:
a base;
a first conducting material layer, formed on the base; and
a second conducting material layer, directly bonded to the first conducting material layer, where a movable comb tooth structure is formed in the second conducting material layer, and an end portion, close to the base, of the movable comb tooth structure is contracted inward relative to a lower surface of the second conducting material layer, so as to enable the movable comb tooth structure to be suspended.

A first cavity is further formed in the first conducting material layer, and the movable comb tooth structure is suspended above the first cavity.

Optionally, the second conducting material layer is further provided with a cantilever region, a second cavity and a stopper are further formed in the first conducting material layer, and the second cavity and the stopper are both located directly under the cantilever region.

In the forming method of the inertial sensor provided by the present invention, the trench is formed in the comb tooth region of the second conducting material layer, so that the movable comb tooth structure formed in the comb tooth region can be spaced from the first conducting material layer; and the thin film layer is further arranged at the bottom of the trench, and the thin film layer can be used for realizing etching blocking while etching the second conducting material layer, so that etching on the second conducting material layer can be stopped at the thin film layer without damaging the first conducting material layer below. Moreover, when etching the second conducting material layer to form the movable comb tooth structure, the bottoms of the comb teeth of the movable comb tooth structure are all fixed to the thin film layer, thereby avoiding damage to the side walls of the comb teeth due to torsion of the comb teeth during etching. In addition, in the forming method provided by the present invention, the thin film layer with a small thickness can be arranged, and thus, only a small etching amount is required for removing the thin film layer, and at this time, other film layers cannot be largely eroded, which is conducive to guaranteeing stability of modules in a device.

### BRIEF DESCRIPTION OF THE DRAWINGS

FIG. 1 is a schematic flowchart of a forming method of an inertial sensor according to an embodiment of the present invention.
FIG. 2 to FIG. 8 are schematic structural diagrams illustrating a preparation process of a forming method of an inertial sensor according to an embodiment of the present invention.

Reference numerals are as follows: 100-first substrate; 110-first base; 120-first insulating layer; 130-first conducting material layer; 130a-first cavity; 130b-second cavity; 130c-first opening; 131-stopper; 200-second substrate; 210-second base; 220-second insulating layer; 230-second conducting material layer; 231-movable comb tooth structure; 230a-trench; 240-thin film layer; 400-electrode; 510-separation opening; 600-seal-capping base plate; 610-seal-capping cavity; and 700-bonding sealing ring.

### DETAILED DESCRIPTION

As mentioned in the background, side walls of comb teeth of a movable comb tooth structure of an inertial sensor prepared by the existing forming method of the inertial sensor are likely to be damaged. Thus, the inventors of the present invention carried out researches and found that one important reason why the side walls of the comb teeth of the movable comb tooth structure are likely to be damaged is that in the process of etching a second substrate to form the movable comb tooth structure, a torsion space of the movable comb tooth structure is released along with constant etching, causing the movable comb tooth structure to easily twist during etching, and at this time, the side walls of the comb teeth are likely to suffer from etching damage.

Therefore, the present invention provides an inertial sensor and a forming method thereof. The forming method includes the following steps.

Step S100: A first substrate with a first conducting material layer and a second substrate with a second conducting material layer are provided, a trench is formed in a surface of a comb tooth region of the second conducting material layer, and a thin film layer is further formed at a bottom of the trench.

Step S200: The second conducting material layer and the first conducting material layer are mutually bonded.

Step S300: At least the comb tooth region of the second conducting material layer is etched, etching is stopped at the thin film layer to form a movable comb tooth structure, and bottoms of comb teeth in the movable comb tooth structure are all fixed to the thin film layer.

Step S400: The thin film layer is removed.

The inertial sensor and the forming method thereof provided by the present invention are further described in detail below in combination with the drawings and specific embodiments. The advantages and features of the present invention will be more clear according to the following description. It should be noted that the drawings all adopt a very simplified form and use an inaccurate scale, which are only intended to conveniently and clearly assist in describing the purposes of the embodiments of the present invention. In addition, relative terms shown in the drawings such as "above", "below", "top", "bottom", "over" and "under" can be used for describing relationships among modules, and these relative terms are intended to cover different orientations among elements besides the orientations depicted in the drawings. For example, if a device is inverted relative to a view in the drawings, it is described that an element above the other element is located below the other element now.

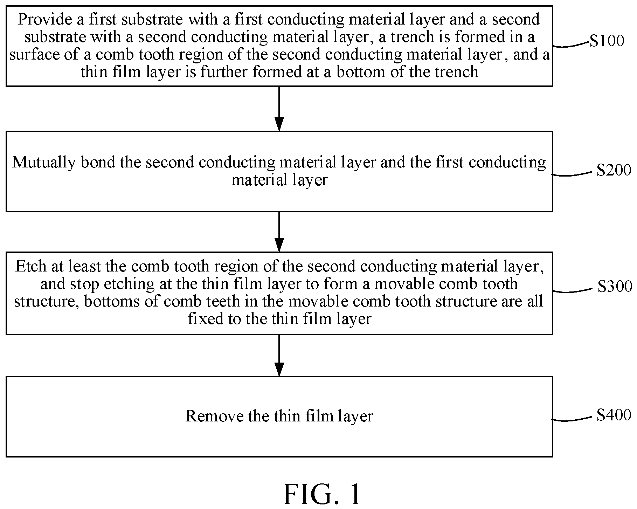

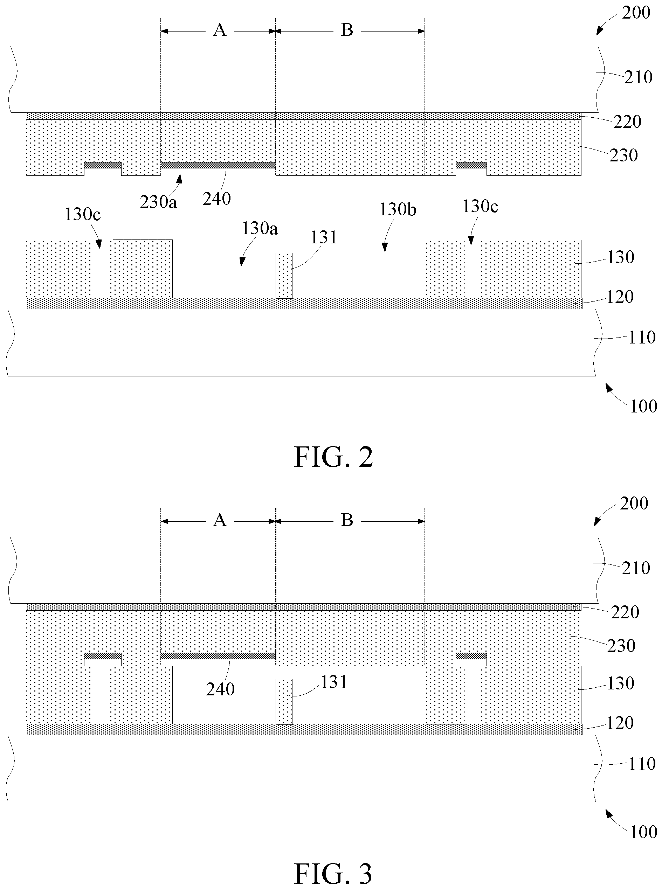

In this embodiment, the forming method of the inertial sensor may include the following step S100 to step S400. The detailed description is made below in combination with FIG. 1 and FIG. 2 to FIG. 8. FIG. 1 is a schematic flowchart of a forming method of an inertial sensor according to an embodiment of the present invention, and FIG. 2 to FIG. 8 are schematic structural diagrams illustrating a preparation process of a forming method of an inertial sensor according to an embodiment of the present invention.

In step S100, referring to FIG. 2 for details, a first substrate 100 with a first conducting material layer 130 and a second substrate 200 with a second conducting material layer 230 are provided.

A trench 230a is formed in a surface of a comb tooth region A of the second conducting material layer 230, and a thin film layer 240 is formed at a bottom of the trench 230a. A material of the thin film layer 240, for example, includes silicon oxide, and the comb tooth region A of the second conducting material layer 230 is used for preparing the movable comb tooth structure. In this embodiment, the thin film layer 240 is only located in the trench 230a, and a thickness of the thin film layer 240 is less than a depth of the trench 230a, so that a top surface of the thin film layer 240 is not higher than that of the second conducting material layer 230. For example, the thickness of the thin film layer 240 may be only a half of the depth of the trench 230a, and the depth of the trench 230a is, for example, 0.5 µm-1.5 µm.

Further, the second conducting material layer 230 is further provided with a cantilever region B, the comb tooth region A is located beside the cantilever region B, and a part of the cantilever region B can constitute a mass block of the inertial sensor.

Further, a first cavity 130a is further formed in the first conducting material layer 130. The first cavity 130a corresponds to the comb tooth region A of the second conducting material layer 230 (i.e., after subsequent bonding of the first substrate 100 and the second substrate 200, the first cavity 130a is aligned with the comb tooth region A). In addition, a second cavity 130b is further formed in the first conducting material layer 130. The second cavity 130b corresponds to the cantilever region B of the second conducting material layer 230 (i.e., after subsequent bonding of the first substrate 100 and the second substrate 200, the second cavity 130b is aligned with the cantilever region B), thereby providing a vibration space for the cantilever region B.

Further, a stopper 131 may also be arranged in the first conducting material layer 130. The stopper 131 corresponds to the cantilever region B of the second conducting material layer 230, so as to limit a vibration range of the cantilever region B, and avoid the problems such as fracture due to excessive vibration of the cantilever region B. Specifically, after subsequent bonding of the first substrate 100 and the second substrate 200, the stopper 131 is located below the cantilever region B, and in this embodiment, the stopper 131 may be further arranged on an edge of the second cavity 130b, so as to perform stopping from the edge of the cantilever region B. Further, a top surface of the stopper 131 is not higher than that of the first conducting material layer 130.

Continuing referring to FIG. 2, a plurality of first openings 130c are further formed in the first conducting material layer 130, and the first openings 130c penetrate through the first conducting material layer 130. The first openings 130c are used for forming separation openings. It should be noted that in the constituted plurality of separation openings, part of the separation openings may also be used for forming alignment marks, thereby ensuring alignment precision of a subsequent patterning process. The detailed description will be made in subsequent steps.

In this embodiment, trenches and thin film layers are also formed in positions, corresponding to the first openings 130c, of the second conducting material layer 230.

Continuing referring to FIG. 2, in this embodiment, the first substrate 100 further includes a first base 110, and the first conducting material layer 130 is formed on the first base 110. A material of the first conducting material layer 130, for example, is an ion-doped silicon material, and a resistance value of the first conducting material layer 130 is, for example, between 0.01 Ω and 0.02 Ω.

In addition, before forming the first conducting material layer 130, a first insulating layer 120 may also be formed on the first base 110. After forming the first insulating layer 120, the first conducting material layer 130 is formed on the first insulating layer 120, and when etching the first conducting material layer 130 for patterning, the first insulating layer 120 may also be used as an etching stop layer. A material of the first insulating layer 120, for example, includes silicon oxide.

Continuing referring to FIG. 2, the second substrate 200 with the second conducting material layer 230 may be the second substrate directly constituted only with the second conducting material layer; or, in this embodiment, the second substrate 200 further includes a second base 210, and the second conducting material layer 230 is formed on the second base 210.

Further, before forming the second conducting material layer 230, a second insulating layer 220 is further formed on the second base 210, and after forming the second insulating layer 220, the second conducting material layer 230 is formed on the second insulating layer 220. A material of the second insulating layer 220, for example, includes silicon oxide.

In an optional solution, a material of the second conducting material layer 230 may be the same as that of the first conducting material layer 130. In this embodiment, the material of the second conducting material layer 230 is, for example, an ion-doped silicon material, and a resistance value of the second conducting material layer 230 is, for example, between 0.01 Ω and 0.02 Ω. Compared with the low-resistance second conducting material layer 230, the second base 210 has a higher resistance value, for example, the resistance value of the second base 210 is between 8 Ω and 12 Ω.

In step S200, referring to FIG. 3 for details, the second substrate 200 and the first substrate 100 are bonded in a direction that the second conducting material layer 230 faces the first conducting material layer 130.

The specific process of bonding the second substrate 200 and the first substrate 100 is to mutually bond the first conducting material layer 130 in the first substrate 100 and the second conducting material layer 230 in the second substrate 200. In this embodiment, both the first conducting material layer 130 and the second conducting material layer 230 are made of the ion-doped silicon material, that is, the first substrate 100 and the second substrate 200 are in silicon-silicon direct bonding, and the bonding process is simple and has high bonding force.

The comb tooth region A of the second conducting material layer 230 corresponds to the first cavity 130a of the first conducting material layer 130, and thus, after bonding the first substrate 100 and the second substrate 200, the trench 230a is located above the first cavity 130a. In addition, the cantilever region B of the second conducting material layer 230 is located above the second cavity 130b.

In the subsequent process, the second conducting material layer 230 is patterned to form the movable comb tooth structure. In this embodiment, the second conducting material layer 230 further has the second insulating layer 220 and the second base 210, and thus, before patterning the second conducting material layer 230, the forming method further includes: the second base 210 and the second insulating layer 220 are removed.

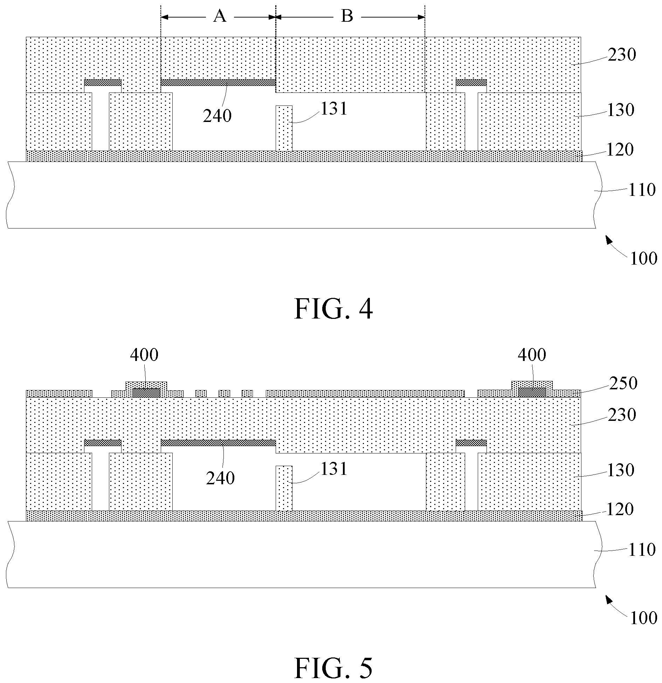

Details are shown in combination with FIG. 3 and FIG. 4, the method for removing the second base 210 and the second insulating layer 220 may include: firstly, the second base 210 is ground to partially remove the second base 210, then the remaining second base 210 is etched by an etching process, etching is stopped at the second insulating layer 220, and then the second insulating layer 220 is removed to expose the second conducting material layer 230.

Specifically, the second base 210 is partially removed by the grinding process, and part of the second base 210 is retained, which can effectively relief mechanical stress of the grinding process acting on the second conducting material layer 230, and avoid hide cracks in the second conducting material layer 230. Then, the remaining second base 210 is etched by the etching process, and when etching the remaining second base 210, the second insulating layer 220 can be utilized for constituting the etching stop layer, thereby avoiding losses of the second conducting material layer 230 below under the protection of the second insulating layer 220, and effectively guaranteeing accurate control over the thickness of the second conducting material layer 230. Further, the remaining second base 210 can be etched by a plasma etching process, so as to improve etching precision of the second base 210. Then, the second insulating layer 220 can be removed by a wet etching process. For example, the material of the second insulating layer 220 may include silicon oxide, and thus, an etching agent adopted in the wet etching process for removing the second insulating layer 220 is, for example, hydrofluoric acid solution.

In an optional solution, before grinding the second base 210, the forming method further includes: a trim process is performed on an edge of the second base 210, so as to remove an edge part of the second base 210, and accordingly, when subsequently performing the grinding process on the second base 210, the problem that the edge part of the thinned second base 210 is suspended and is likely to fracture can be avoided.

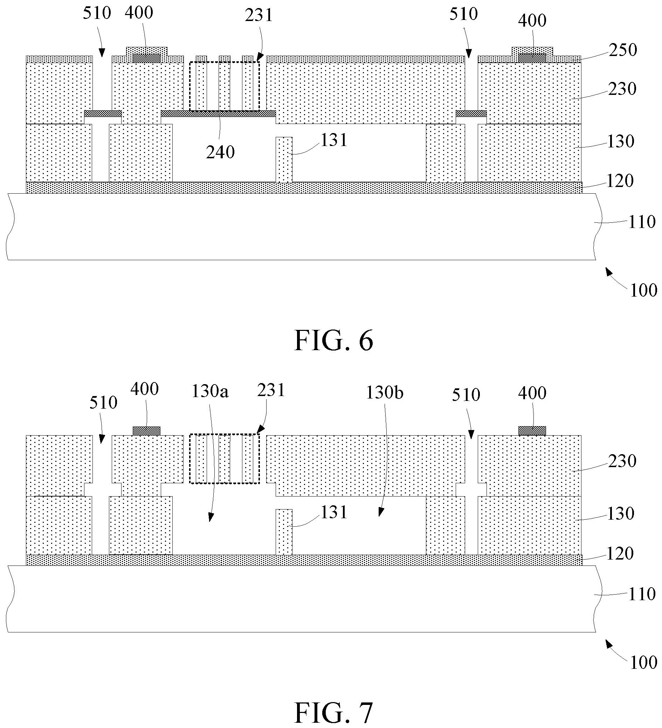

In step S300, referring to FIG. 5 and FIG. 6 for details, at least the comb tooth region A of the second conducting material layer 230 is etched; etching is stopped at the thin film layer 240 to form the movable comb tooth structure 231; and the bottoms of the comb teeth in the movable comb tooth structure 231 are all fixed to the thin film layer 240.

Specifically, a pattern of the movable comb tooth structure can be defined by a second mask layer, and the second conducting material layer 230 is etched based on the second mask layer, so as to form the movable comb tooth structure 231, and the method, for example, includes the following steps.

Step 1: Referring to FIG. 5, a second mask layer 250 is formed on the second conducting material layer 230, and the pattern of the movable comb tooth structure is defined in the second mask layer 250.

Step 2: Referring to FIG. 6, the second conducting material layer 230 is etched with the second mask layer 250 as a mask, so as to form the movable comb tooth structure 231, and when etching the second conducting material layer 230, the thin film layer 240 is used as the etching stop layer to stop etching at the thin film layer 240. Specifically, the method for etching the second conducting material layer 230 is, for example, to use the plasma etching process for etching the second conducting material layer 230, so as to improve the etching precision.

It should be noted that by arranging the thin film layer 240, on the one hand, the function of etching blocking can be realized, and accurate control over the etching process of the second conducting material layer 230 is improved; and on the other hand, based on the blocking of the thin film layer 240, a film layer below the thin film layer 240 can be effectively protected against etching damage. In addition, it should be understood that the bottoms of the comb teeth in the formed movable comb tooth structure 231 are all fixed to the thin film layer 240, and thus, as the etching process continues, a torsion space of the movable comb tooth structure 231 is released, but because all the comb teeth are fixed to the thin film layer 240, the comb teeth cannot twist at random, thereby avoiding damage to the side walls of the comb teeth due to torsion of the comb teeth during etching. Particularly, to ensure that patterns of the comb teeth can be completely and accurately etched, a certain over etching amount can be generally increased, and the plasma etching process with higher precision can be adopted for etching. In this embodiment, the comb teeth can be stably fixed by the thin film layer 240, and thus, even under the large etching amount, damage to the side walls of the comb teeth from plasma can still be effectively relieved.

Further, before patterning the second conducting material layer 230, the forming method further includes: a plurality of electrodes 400 are formed on the second conducting material layer 230. At least part of the plurality of electrodes 400 are used for being electrically connected to the movable comb tooth structure 231. Specifically, the plurality of electrodes 400 include two first electrodes which are electrically isolated from each other, and the two first electrodes are respectively electrically connected to two sets of comb teeth in the movable comb tooth structure 231.

Further, the plurality of electrodes 400 further include a second electrode, and the second electrode is used for being electrically connected to the cantilever region B of the second conducting material layer 230.

In this embodiment, the plurality of electrodes 400 can be electrically isolated from each other by separation openings 510. Specifically, through the separation openings 510, the first electrodes and the second electrode in the plurality of electrodes cannot be mutually connected by the conducting material layers (including the first conducting material layer 130 and the second conducting material layer 230).

A forming method of the separation openings 510 may include: during patterning the second conducting material layer 230, second openings are further formed in the second conducting material layer 230, bottoms of the second openings are stopped at the thin film layer as well and located above the first openings 130c of the first conducting material layer 130, and thus, the first openings 130c and the second openings are in up-down mutual communication to form the separation openings 510, thereby utilizing the separation openings 510 for dividing the plurality of mutually separated electrodes.

It should be understood that based on layout limitations, the drawings only exemplarily illustrate two separation openings 510 and two electrodes 400, and it should be understood that the electrodes 400 for connecting different modules are electrically isolated by the separation openings 510. In addition, the first electrodes can be electrically connected to the movable comb tooth structure 231, and the second electrode can be electrically connected to the cantilever region B through other interconnection structures.

In step S400, referring to FIG. 7 for details, the thin film layer 240 is removed. In this embodiment, the forming method further includes: the second mask layer 250 is removed. At this time, the movable comb tooth structure 231 is suspended above the first cavity 130a.

As mentioned above, the thin film layer 240 is relatively thin, and thus, the thin film layer 240 can be depleted with a small etching amount. Specifically, the thin film layer 240 can be eroded by a gas phase corrosive agent. In this embodiment, the thin film layer 240 is removed by a vapor phase hydrogen fluoride (VHF) fumigation corrosion process. Compared with the wet etching process, the gas phase corrosive agent is utilized for eroding the thin film layer 240, which can effectively avoid the problems such as adhesion and torsion likely to occur between the adjacent comb teeth caused by corrosive liquid in the wet etching process.

In addition, in an optional solution, the material of the first insulating layer 120 may be the same as that of the thin film layer 240 (e.g., both including silicon oxide), and accordingly, when etching the thin film layer 240, a trace amount of the first insulating layer 120 will be consumed. However, as mentioned above, the etching amount of the thin film layer 240 is small, and thus, the first insulating layer 120 cannot be largely consumed, which is conducive to guaranteeing the stable supporting of the first insulating layer 120 to a film layer above the first insulating layer.

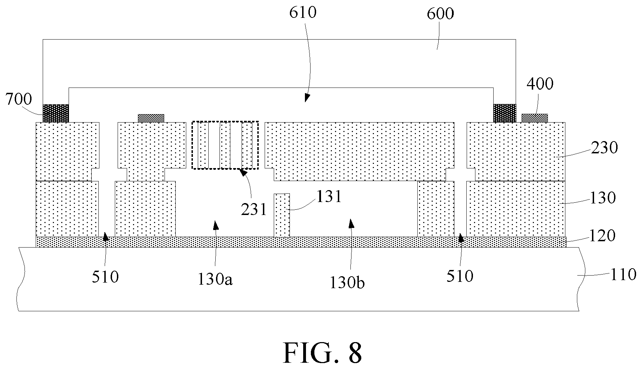

In a further solution, referring to FIG. 8 for details, the forming method of the inertial sensor further includes: a seal-capping base plate 600 is bonded onto the second conducting material layer 230. A seal-capping cavity 610 is formed in a surface, facing towards the second conducting material layer 230, of the seal-capping base plate 600, and the seal-capping cavity 610 faces the comb tooth region A and the cantilever region B. Part of the plurality of electrodes 400 may be sealed and capped within the seal-capping cavity 610, and the other part of electrodes may be located outside the seal-capping cavity 610 for electrically connecting an external circuit.

Continuing referring to FIG. 8, the seal-capping base plate 600 and the second conducting material layer 230 may be specifically mutually bonded through two bonding rings. For example, a first bonding ring is formed on a top surface, surrounding the seal-capping cavity 610, of the seal-capping base plate 600, a second bonding ring is formed at a corresponding position of the second conducting material layer 230, and during bonding, the first bonding ring and the second bonding ring are mutually bonded and connected to form a bonding sealing ring 700.

In a specific implementation solution, a material of one of the first bonding ring and the second bonding ring is aluminum, and a material of the other bonding ring is germanium, thereby realizing aluminum-germanium bonding between the first bonding ring and the second bonding ring. Alternatively, in another solution, the material of both the first bonding ring and the second bonding ring is gold, thereby realizing gold-gold bonding between the first bonding ring and the second bonding ring. Alternatively, the material of one of the first bonding ring and the second bonding ring is gold, and the material of the other bonding ring is silicon, thereby realizing gold-silicon bonding between the first bonding ring and the second bonding ring.

Based on the above forming method, this embodiment further provides an inertial sensor. Referring to FIG. 7 and FIG. 8 for details, the inertial sensor includes: a base (i.e., a first base 110 shown in FIG. 7); a first conducting material layer 130 formed on the base; and a second conducting material layer 230 directly bonded to the first conducting material layer 130. A movable comb tooth structure 231 is formed in the second conducting material layer 230, and an end portion, close to the base, of the movable comb tooth structure 231 is contracted inward relative to a bonding surface of the second conducting material layer 230, so as to enable the movable comb tooth structure 231 to be suspended.

A first cavity 130a may also be formed in the first conducting material layer 130, and the movable comb tooth structure 231 is suspended above the first cavity 130a. Further, the second conducting material layer 230 is further provided with a cantilever region B, and a second cavity 130b and a stopper 131 are further formed in the first conducting material layer 130. The second cavity 130b and the stopper 131 are both located directly under the cantilever region B. In this embodiment, a top surface of the stopper 131 is lower than a bonding surface of the first conducting material layer 130.

In this embodiment, the first conducting material layer 130 and the second conducting material layer 230 are, for example, directly bonded based on a silicon-silicon bonding process, and the process is simple and has high bonding force.

Continuing referring to FIG. 7, the inertial sensor further includes: a plurality of electrodes 400 formed on the second conducting material layer 230 and electrically isolated from each other. A part of the plurality of electrodes 400 are used for being electrically connected to the movable comb tooth structure 231, and a part of the plurality of electrodes 400 are used for being electrically connected to the cantilever region B. It should be understood that the drawings in this embodiment only exemplarily illustrate two electrodes 400, however, in practical application, the number, location and connection mode with corresponding modules of the electrodes can be correspondingly adjusted according to specific conditions.

Further, up-down communicating openings are further formed in both the first conducting material layer 130 and the second conducting material layer 230, so as to form separation openings 510, and the plurality of electrodes 400 are electrically isolated from each other by the separation openings 510, so as to be respectively and independently electrically connected to the corresponding movable comb tooth structure 231 and the corresponding cantilever region B, and the like.

It should be understood that the end portion of the movable comb tooth structure 231 is contracted inward through the trench in the second conducting material layer 230, and thus, the movable comb tooth structure 231 can be suspended. Compared with a conventional process in which a suspended movable comb tooth structure is realized through a spacer layer, this embodiment not only can guarantee that the movable comb tooth structure 231 is spaced from the second conducting material layer, but also can combine the thin film layer to further improve the quality of the formed comb tooth structure.

It should be noted that although the present invention has been disclosed by the preferred embodiments above, the above embodiments are not intended to limit the present invention.

## Claims

1. A forming method of an inertial sensor, comprising:
providing a first substrate (100) with a first conducting material layer (130) and a second substrate (200) with a second conducting material layer (230), wherein the second conducting material layer (230) has a comb tooth region, a trench (230a) is formed in a surface of the comb tooth region, and a thin film layer (240) is further formed at a bottom of the trench (230a);
mutually bonding the second conducting material layer (230) and the first conducting material layer (130); and
etching at least the comb tooth region of the second conducting material layer (230), and stopping etching at the thin film layer (240) to form a movable comb tooth structure (231), wherein bottoms of comb teeth in the movable comb tooth structure (231) are all fixed to the thin film layer (240); and
removing the thin film layer (240).

2. The forming method of the inertial sensor according to claim 1, wherein a thickness of the thin film layer (240) is less than a depth of the trench (230a).

3. The forming method of the inertial sensor according to claim 1, wherein after bonding the second conducting material layer (230) and the first conducting material layer (130), the forming method further comprises:
forming a plurality of electrodes (400) on the second conducting material layer (230), wherein at least part of the plurality of electrodes (400) are used for being electrically connected to the movable comb tooth structure (231).

4. The forming method of the inertial sensor according to claim 3, wherein first openings (130c) are further formed in the first conducting material layer (130), and when etching the second conducting material layer (230), second openings are further formed in the second conducting material layer (230), the second openings communicate with the first openings (130c) to form separation openings (510), and the plurality of electrodes (400) are electrically isolated from each other by the separation openings (510).

5. The forming method of the inertial sensor according to claim 1, wherein the first substrate (100) further comprises a first base (110) and a first insulating layer (120) formed between the first base (110) and the first conducting material layer (130), and a first cavity (130a) exposing the first insulating layer (120), a second cavity (130b) and a stopper (131) located on the first insulating layer (120) are further formed in the first conducting material layer (130).

6. The forming method of the inertial sensor according to claim 5, wherein a material of the thin film layer (240) is the same as that of the first insulating layer (120).

7. The forming method of the inertial sensor according to claim 1, wherein a first cavity (130a) is formed in the first conducting material layer (130), and after bonding the first conducting material layer (130) and the second conducting material layer (230), the comb tooth region is suspended above the first cavity (130a), and a lower part of the comb tooth region corresponds to the first cavity (130a).

8. The forming method of the inertial sensor according to claim 1, wherein the second conducting material layer (230) is further provided with a cantilever region, a second cavity (130b) and a stopper (131) are further formed in the first conducting material layer (130), and after bonding the first conducting material layer (130) and the second conducting material layer (230), the second cavity (130b) and the stopper (131) are both located directly under the cantilever region, and a lower part of the cantilever region corresponds to the second cavity (130b).

9. The forming method of the inertial sensor according to claim 1, wherein the second substrate (200) further comprises a second base (210) and a second insulating layer (220) formed between the second base (210) and the second conducting material layer (230); and
before etching the second conducting material layer (230), the forming method further comprises: grinding the second base (210) to partially remove the second base (210), then etching the remaining second base (210) by an etching process, stopping etching at the second insulating layer (220), and then removing the second insulating layer (220) to expose the second conducting material layer (230).

10. The forming method of the inertial sensor according to claim 1, wherein the method for etching the second conducting material layer (230) to form the movable comb tooth structure (231) comprises: adopting a plasma etching process for etching the second conducting material layer (230).

11. An inertial sensor prepared by the forming method according to any one of claims 1 to 10, comprising:
a base;
a first conducting material layer (130), formed on the base; and
a second conducting material layer (230), directly bonded to the first conducting material layer (130), wherein a movable comb tooth structure (231) is formed in a comb tooth region of the second conducting material layer (230), and an end portion, close to the base, of the movable comb tooth structure (231) is contracted inward relative to a bonding surface of the second conducting material layer (230), so as to enable the movable comb tooth structure (231) to be suspended, **characterized in that**:
a first cavity (130a) is further formed in the first conducting material layer (130), the movable comb tooth structure (231) is suspended above the first cavity (130a), and a lower part of the comb tooth region corresponds to the first cavity (130a).

12. The inertial sensor according to claim 11, wherein the second conducting material layer (230) is further provided with a cantilever region, a second cavity (130b) and a stopper (131) are further formed in the first conducting material layer (130), the second cavity (130b) and the stopper (131) are both located directly under the cantilever region, and a lower part of the cantilever region corresponds to the second cavity (130b).

13. The inertial sensor according to claim 11, further comprising a first insulating layer (120) located between the base and the first conducting material layer (130), wherein the first insulating layer (120) has a portion exposed in a first cavity (130a) and a second cavity (130b), and a stopper (131) in the first conducting material layer (130) is arranged on the first insulating layer (120).

## Patentansprüche

1. Verfahren zum Ausbilden eines Trägheitssensors, umfassend:
Bereitstellen eines ersten Substrats (100) mit einer ersten leitenden Materialschicht (130) und eines zweiten Substrats (200) mit einer zweiten leitenden Materialschicht (230), wobei die zweite leitende Materialschicht (230) einen Kammzahnbereich aufweist, ein Graben (230a) in einer Oberfläche des Kammzahnbereichs ausgebildet ist und ferner eine Dünnfilmschicht (240) an einem Boden des Grabens (230a) ausgebildet ist;
gegenseitiges Verbinden der zweiten leitenden Materialschicht (230) und der ersten leitenden Materialschicht (130); und
Ätzen zumindest des Kammzahnbereichs der zweiten leitenden Materialschicht (230) und Stoppen des Ätzens an der Dünnfilmschicht (240), um eine bewegliche Kammzahnstruktur (231) auszubilden, wobei Böden von Kammzähnen in der beweglichen Kammzahnstruktur (231) alle an der Dünnfilmschicht (240) befestigt sind; und
Entfernen der Dünnfilmschicht (240).

2. Verfahren zum Ausbilden des Trägheitssensors nach Anspruch 1, wobei eine Dicke der Dünnfilmschicht (240) geringer als eine Tiefe des Grabens (230a) ist.

3. Verfahren zum Ausbilden des Trägheitssensors nach Anspruch 1, wobei nach dem Verbinden der zweiten leitenden Materialschicht (230) und der ersten leitenden Materialschicht (130) das Verfahren zum Ausbilden ferner umfasst:
Ausbilden mehrerer Elektroden (400) auf der zweiten leitenden Materialschicht (230), wobei zumindest ein Teil der mehreren Elektroden (400) verwendet wird, um elektrisch mit der beweglichen Kammzahnstruktur (231) verbunden zu werden.

4. Verfahren zum Ausbilden des Trägheitssensors nach Anspruch 3, wobei ferner erste Öffnungen (130c) in der ersten leitenden Materialschicht (130) ausgebildet werden, und wenn die zweite leitende Materialschicht (230) geätzt wird, ferner zweite Öffnungen in der zweiten leitenden Materialschicht (230) ausgebildet werden, wobei die zweiten Öffnungen mit den ersten Öffnungen (130c) in Verbindung stehen, um Trennöffnungen (510) auszubilden, und die mehreren Elektroden (400) durch die Trennöffnungen (510) elektrisch voneinander isoliert sind.

5. Verfahren zum Ausbilden des Trägheitssensors nach Anspruch 1, wobei das erste Substrat (100) ferner eine erste Basis (110) und eine erste Isolierschicht (120), die zwischen der ersten Basis (110) und der ersten leitenden Materialschicht (130) ausgebildet ist, umfasst, und ferner ein erster Hohlraum (130a), der die erste Isolierschicht (120) freilegt, ein zweiter Hohlraum (130b) und ein Stopper (131), der sich auf der ersten Isolierschicht (120) befindet, in der ersten leitenden Materialschicht (130) ausgebildet sind.

6. Verfahren zum Ausbilden des Trägheitssensors nach Anspruch 5, wobei ein Material der Dünnfilmschicht (240) das gleiche wie das der ersten Isolierschicht (120) ist.

7. Verfahren zum Ausbilden des Trägheitssensors nach Anspruch 1, wobei ein erster Hohlraum (130a) in der ersten leitenden Materialschicht (130) ausgebildet ist und nach dem Verbinden der ersten leitenden Materialschicht (130) und der zweiten leitenden Materialschicht (230) der Kammzahnbereich über dem ersten Hohlraum (130a) aufgehängt ist und ein unterer Teil des Kammzahnbereichs dem ersten Hohlraum (130a) entspricht.

8. Verfahren zum Ausbilden des Trägheitssensors nach Anspruch 1, wobei die zweite leitende Materialschicht (230) ferner mit einem freitragenden Bereich versehen ist, ferner ein zweiter Hohlraum (130b) und ein Stopper (131) in der ersten leitenden Materialschicht (130) ausgebildet sind und nach dem Verbinden der ersten leitenden Materialschicht (130) und der zweiten leitenden Materialschicht (230) der zweite Hohlraum (130b) und der Stopper (131) beide direkt unter dem freitragenden Bereich angeordnet sind und ein unterer Teil des freitragenden Bereichs dem zweiten Hohlraum (130b) entspricht.

9. Verfahren zum Ausbilden des Trägheitssensors nach Anspruch 1, wobei das zweite Substrat (200) ferner eine zweite Basis (210) und eine zweite Isolierschicht (220) umfasst, die zwischen der zweiten Basis (210) und der zweiten leitenden Materialschicht (230) ausgebildet ist; und
vor dem Ätzen der zweiten leitenden Materialschicht (230) das Verfahren zum Ausbilden ferner umfasst: Schleifen der zweiten Basis (210), um die zweite Basis (210) teilweise zu entfernen, dann Ätzen der verbleibenden zweiten Basis (210) durch einen Ätzprozess, Stoppen des Ätzens an der zweiten Isolierschicht (220) und dann Entfernen der zweiten Isolierschicht (220), um die zweite leitende Materialschicht (230) freizulegen.

10. Verfahren zum Ausbilden des Trägheitssensors nach Anspruch 1, wobei das Verfahren zum Ätzen der zweiten leitenden Materialschicht (230), um die bewegliche Kammzahnstruktur (231) auszubilden, umfasst: Anwenden eines Plasmaätzprozesses zum Ätzen der zweiten leitenden Materialschicht (230).

11. Trägheitssensor, der durch das Verfahren zum Ausbilden nach einem der Ansprüche 1 bis 10 hergestellt ist, umfassend:
eine Basis;
eine erste leitende Materialschicht (130), die auf der Basis ausgebildet ist; und
eine zweite leitende Materialschicht (230), die direkt mit der ersten leitenden Materialschicht (130) verbunden ist, wobei eine bewegliche Kammzahnstruktur (231) in einem Kammzahnbereich der zweiten leitenden Materialschicht (230) ausgebildet ist und ein Endabschnitt, nahe der Basis, der beweglichen Kammzahnstruktur (231) relativ zu einer Verbindungsfläche der zweiten leitenden Materialschicht (230) nach innen zusammengezogen ist, um zu ermöglichen, dass die bewegliche Kammzahnstruktur (231) aufgehängt wird, **dadurch gekennzeichnet, dass**:
ein erster Hohlraum (130a) ferner in der ersten leitenden Materialschicht (130) ausgebildet ist, die bewegliche Kammzahnstruktur (231) über dem ersten Hohlraum (130a) aufgehängt ist und ein unterer Teil des Kammzahnbereichs dem ersten Hohlraum (130a) entspricht.

12. Trägheitssensor nach Anspruch 11, wobei die zweite leitende Materialschicht (230) ferner mit einem freitragenden Bereich versehen ist, ferner ein zweiter Hohlraum (130b) und ein Stopper (131) in der ersten leitenden Materialschicht (130) ausgebildet sind, der zweite Hohlraum (130b) und der Stopper (131) beide direkt unter dem freitragenden Bereich angeordnet sind und ein unterer Teil des freitragenden Bereichs dem zweiten Hohlraum (130b) entspricht.

13. Trägheitssensor nach Anspruch 11, ferner umfassend eine erste Isolierschicht (120), die zwischen der Basis und der ersten leitenden Materialschicht (130) angeordnet ist, wobei die erste Isolierschicht (120) einen Abschnitt aufweist, der in einem ersten Hohlraum (130a) und einem zweiten Hohlraum (130b) freiliegt, und ein Stopper (131) in der ersten leitenden Materialschicht (130) auf der ersten Isolierschicht (120) angeordnet ist.

## Revendications

1. Procédé de formation d'un capteur inertiel, consistant à :
fournir un premier substrat (100) avec une première couche de matériau conducteur (130) et un second substrat (200) avec une seconde couche de matériau conducteur (230), dans lequel la seconde couche de matériau conducteur (230) a une région de dents de peigne, une tranchée (230a) est formée dans une surface de la région de dents de peigne, et une couche de film mince (240) est en outre formée au fond de la tranchée (230a) ;
lier mutuellement la seconde couche de matériau conducteur (230) et la première couche de matériau conducteur (130) ; et
graver au moins la région des dents de peigne de la seconde couche de matériau conducteur (230) et arrêter la gravure sur la couche de film mince (240) pour former une structure de dents de peigne mobile (231), dans lequel les fonds des dents de peigne dans la structure de dents de peigne mobile (231) sont tous fixés à la couche de film mince (240) ; et
retirer la couche de film mince (240).

2. Procédé de formation du capteur inertiel selon la revendication 1, dans lequel l'épaisseur de la couche de film mince (240) est inférieure à la profondeur de la tranchée (230a).

3. Procédé de formation du capteur inertiel selon la revendication 1, dans lequel, après avoir lié la seconde couche de matériau conducteur (230) et de la première couche de matériau conducteur (130), le procédé de formation consiste en outre à :
former une pluralité d'électrodes (400) sur la seconde couche de matériau conducteur (230), dans lequel au moins une partie de la pluralité d'électrodes (400) est utilisée pour être connectée électriquement à la structure des dents de peigne mobile (231).

4. Procédé de formation du capteur inertiel selon la revendication 3, dans lequel les premières ouvertures (130c) sont en outre formées dans la première couche de matériau conducteur (130), et lors de la gravure de la seconde couche de matériau conducteur (230), les secondes ouvertures sont en outre formées dans la seconde couche de matériau conducteur (230), les secondes ouvertures communiquent avec les premières ouvertures (130c) pour former des ouvertures de séparation (510), et la pluralité d'électrodes (400) sont électriquement isolées les unes des autres par les ouvertures de séparation (510).

5. Procédé de formation du capteur inertiel selon la revendication 1, dans lequel le premier substrat (100) comprend en outre une première base (110) et une première couche isolante (120) formée entre la première base (110) et la première couche de matériau conducteur (130), et une première cavité (130a) exposant la première couche isolante (120), une seconde cavité (130b) et un bouchon (131) situé sur la première couche isolante (120) sont en outre formés dans la première couche de matériau conducteur (130).

6. Procédé de formation du capteur inertiel selon la revendication 5, dans lequel un matériau de la couche de film mince (240) est le même que celui de la première couche isolante (120).

7. Procédé de formation du capteur inertiel selon la revendication 1, dans lequel une première cavité (130a) est formée dans la première couche de matériau conducteur (130), et après avoir lié la première couche de matériau conducteur (130) et de la seconde couche de matériau conducteur (230), la région de dents de peigne est suspendue au-dessus de la première cavité (130a) et une partie inférieure de la région de dents de peigne correspond à la première cavité (130a).

8. Procédé de formation du capteur inertiel selon la revendication 1, dans lequel la seconde couche de matériau conducteur (230) est en outre pourvue d'une région en porte-à-faux, une seconde cavité (130b) et un bouchon (131) sont en outre formés dans la première couche de matériau conducteur (130), et après avoir lié la première couche de matériau conducteur (130) et de la seconde couche de matériau conducteur (230), la seconde cavité (130b) et le bouchon (131) sont tous deux situés directement sous la région en porte-à-faux, et une partie inférieure de la région en porte-à-faux correspond à la seconde cavité (130b).

9. Procédé de formation du capteur inertiel selon la revendication 1, dans lequel le second substrat (200) comprend en outre une seconde base (210) et une seconde couche isolante (220) formée entre la seconde base (210) et la seconde couche de matériau conducteur (230) ; et
avant la gravure de la seconde couche de matériau conducteur (230), le procédé de formation consiste en outre à : meuler la seconde base (210) pour enlever partiellement la seconde base (210), graver la seconde base (210) restante par un processus de gravure, arrêter la gravure au niveau de la seconde couche isolante (220), puis enlever la seconde couche isolante (220) pour exposer la seconde couche de matériau conducteur (230).

10. Procédé de formation du capteur inertiel selon la revendication 1, dans lequel le procédé de gravure de la seconde couche de matériau conducteur (230) pour former la structure de dents de peigne mobile (231) consiste à : adopter un processus de gravure au plasma pour la gravure de la seconde couche de matériau conducteur (230).

11. Capteur inertiel préparé par le procédé de formation selon l'une quelconque des revendications 1 à 10, comprenant :
une base ;
une première couche de matériau conducteur (130), formée sur la base ; et
une seconde couche de matériau conducteur (230), directement liée à la première couche de matériau conducteur (130), dans lequel une structure de dents de peigne mobile (231) est formée dans une région de dents de peigne de la seconde couche de matériau conducteur (230), et une partie d'extrémité, proche de la base, de la structure de dents de peigne mobile (231) est contractée vers l'intérieur par rapport à une surface de liaison de la seconde couche de matériau conducteur (230) afin de permettre à la structure de dents de peigne mobile (231) d'être suspendue, **caractérisé en ce que** :
une première cavité (130a) est en outre formée dans la première couche de matériau conducteur (130), la structure à dents de peigne mobile (231) est suspendue au-dessus de la première cavité (130a), et une partie inférieure de la région à dents de peigne correspond à la première cavité (130a).

12. Capteur inertiel selon la revendication 11, dans lequel la seconde couche de matériau conducteur (230) est en outre pourvue d'une région en porte-à-faux, une seconde cavité (130b) et un bouchon (131) sont en outre formés dans la première couche de matériau conducteur (130), la seconde cavité (130b) et le bouchon (131) sont tous deux situés directement sous la région en porte-à-faux et une partie inférieure de la région en porte-à-faux correspond à la seconde cavité (130b).

13. Capteur inertiel selon la revendication 11, comprenant en outre une première couche isolante (120) située entre la base et la première couche de matériau conducteur (130), dans lequel la première couche isolante (120) a une partie exposée dans une première cavité (130a) et une seconde cavité (130b), et un bouchon (131) dans la première couche de matériau conducteur (130) est disposé sur la première couche isolante (120).
